# EUROPEAN PATENT APPLICATION

(11) **EP 4 287 785 A1**
(43) Date of publication of application: **06.12.2023**
(21) Application number: 22177225.4
(22) Date of filing: 03.06.2022
(51) Int. Cl.: H05K 1/02, H05K 1/18, H05K 1/11

(54) **COMPONENT CARRIER WITH EMBEDDED ELECTRONIC SWITCH COMPONENTS AND A CAPACITOR DEVICE**

(71) Applicant: AT & S Austria Technologie & Systemtechnik Aktiengesellschaft, 8700 Leoben-Hinterberg (AT)
(72) Inventor: Weis, Gerald, 8600 Bruck an der Mur (AT); Frauwallner, Rainer, 8612 Tragöß-St. Katharein (AT)
(74) Representative: Dilg, Haeusler, Schindelmann Patentanwaltsgesellschaft mbH

(57) **Abstract**

It is described a component carrier (100), wherein the component carrier (100) comprises:
i) a stack (101) comprising at least one electrically conductive layer structure (104) and/or at least one electrically insulating layer structure (102);
ii) a first electronic switch component (110) and a second electronic switch component (120) embedded side-by-side in the stack (101); and
iii) a capacitor device (130), electrically connected in parallel to the first electronic switch component (110) and the second electronic switch component (120);

wherein the capacitor device (130) is assembled, in particular surface-mounted, to the stack (101), so that
the first electronic switch component (110) and the second electronic switch component (120) are at least partially arranged below the capacitor device (130) in a direction (z) perpendicular to the directions of main extension (x, y) of the component carrier (100).

## Description

### Field of the Invention

The invention relates to a component carrier with a layer stack, at least two embedded electronic switch components, in particular transistor components, and a capacitor device. Further, the invention relates to a method of manufacturing the component carrier.

Accordingly, the invention may relate to the technical field of component carriers such as printed circuit boards or IC substrates and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and electromagnetically reliable so as to be operable even under harsh conditions.

In particular, efficient integration of an electronic switch function, such as a transistor function, in a component carrier may be seen as a challenge. Electronic switches can produce a high amount of heat during operation, thus there may be a constant risk of overheating, when embedding an electronic switch in a component carrier. For example, transistor can be applied e.g. as switching devices, however, in case of high frequency currents, the performance may significantly drop together with the signal performance.

### Summary of the Invention

There may be a need to integrate an electronic switch, in particular a transistor, function in a component carrier in a way to enable a high thermal performance and a compact design.

A component carrier and a method of manufacturing are provided.

According to an aspect of the invention, there is described a component carrier, wherein the component carrier comprises:
i) a stack comprising at least one electrically conductive layer structure and/or at least one electrically insulating layer structure (e.g. 2 or more, in particular 4 or more, more in particular 6 or more, insulating layers);
ii) a first electronic switch (in particular first transistor) component and a second electronic switch (in particular second transistor component) (in particular connected in series, more in particular forming a half-bridge circuit) assembled (in particular embedded and/or surface-mounted) side-by-side to the stack (particularly on the same vertical level); and
iii) a capacitor device, electrically connected in parallel to the first electronic switch component and the second electronic switch component.

The capacitor device is assembled (in particular surface-mounted or embedded) to the stack, so that the first electronic switch component and the second electronic switch component are at least partially arranged below the capacitor device in a direction (along the z-direction) perpendicular to the directions of main extension (x, y plane) of the component carrier.

According to a further aspect of the invention, there is described a method of manufacturing a component carrier, the method comprises:
i) forming a stack comprising at least one electrically conductive layer structure and/or at least one electrically insulating layer structure;
ii) assembling (in particular embedding) a first electronic switch component and a second electronic switch component side-by-side to the stack; and
iii) assembling (in particular surface-mounting or embedding) a capacitor device to the stack and electrically connecting the capacitor device in parallel to the first electronic switch component and the second electronic switch component, so that the first electronic switch component and the second electronic switch component are at least partially arranged below the capacitor device in a direction (z) perpendicular to the directions of main extension (x, y) of the component carrier.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present document, the term "electronic switch component" may particularly denote an electronic member which fulfills a switching function, in particular the function of exactly one electronic switch. An example for an electronic switch may be a transistor. Such a transistor may be a field effect transistor (in particular a MOSFET, metal oxide semiconductor field effect transistor, and/or a JFET, junction field-effect transistor) comprising enhancement mode and/or depletion mode or a bipolar transistor (in particular an IGBT, insulated gate bipolar transistor). Preferably, the electronic switch component is embodied as a semiconductor chip with an integrated transistor. In other words, the electronic switch component may be a transistor chip. For instance, the respective electronic switch component may be manufactured in semiconductor technology, in particular in silicon technology or in silicon carbide technology or in gallium nitride technology. For the electronic switch, materials such as InP, GaAs, or Ge-based materials may be used. In an embodiment, the electronic switch is configured as one of a bipolar transistor in NPN or PNP configuration, an IGBT.

In an embodiment, a high-side or a low-side switch pack could consist out of one or more transistor(s) in parallel. These two switch packs may then be connected in series to a half bridge configuration.

The two electronic switch components may be embodied as two separate chips, i.e. one chip per electronic switch. The two electronic switch components may be of identical type, or may be of different type. In an example, electronic switches used may include either Hemts (high electron mobility transistors) or SiC devices, in particular in horizontal (planar) configuration.

In the context of the present document, the term "electronic switch components embedded side-by-side" may particularly denote that the electronic switch components are arranged at least partially in juxtaposition. Their vertical extension ranges can coincide, can at least partially overlap, or a vertical extension range of one electronic switch component may be completely within a vertical extension range of the other electronic switch component. For instance, the electronic switch components may be only laterally spaced from one another rather than being arranged on top of one another, i.e. one above the other. In particular, the electronic switch components may be located so that their side walls face each other, in particular with a lateral gap in between (which gap may be filled with material of the stack). Upper main surfaces of the electronic switch components may be at least substantially at the same vertical level, for instance may be aligned. Lower main surfaces of the electronic switch components may be at least substantially at the same vertical level, for instance may be aligned. The electronic switch components may in particular be embedded within the same layer structure or between the same layer structures of the stack. The electronic switch components may be located at the same vertical level, for instance may have coinciding centres of gravity in vertical direction.

In the context of the present document, the term "capacitor device" may particularly denote any device that can be applied as a capacitor, i.e. fulfill a capacitor functionality. A capacitor device may comprise exactly one capacitor or two or more capacitor-(element)s. A capacitor comprises in general two planar electrodes that sandwich a dielectric layer in between. In the context of component carriers, a capacitor may be applied e.g. as a low impedance power supply for short surges of current, in particular switching current that is associated with switching an electronic component. In an example, one or more multi-layer ceramic capacitors (MLCC) may be applied as the capacitor(s) of the capacitor device. Further examples may include: electrolyte capacitor, tantal capacitor, film capacitor, ceralink capacitor (in particular lead lanthanum zirconate titanate (PLZT)).

According to an exemplary embodiment, the invention may be based on the idea that an electronic switch function may be integrated in a component carrier in a way to enable a high thermal performance, a compact design, increased switching performance, and lower EMI impacts, when two electronic switch components are embedded side-by-side in the component carrier layer stack, and are further connected to a capacitor device that is (at least partially) arranged above the electronic switch components (in the vertical direction). With the described architecture, the distances between the electronic switch components and the capacitor device can be minimized and optimized to yield the maximum effect. The capacitor device installed spatially close to the electronic switch components (which in particular form a half bridge) can supply the electronic switches with high frequent currents, which may function most efficiently for short distances. By providing such a commutation/current path, commutation loop inductance and parasitics may be reduced/avoided (may result in low voltage overshoots and/or avoids ringing, which may be also true for the gate drive circuit), thereby also reducing/avoiding low voltage overshoots and ringing. As a result, an excellent signal performance may be obtained.

In this manner, there is provided an efficient and compact switching cell in the component carrier stack that can reliably handle low-, mid- and high current ranges in a flexible manner. For example, in a first commutation path, a low current may pass only through the electronic switch component, while, in a second commutation path, a high frequency current may pass through the electronic switch components and the capacitor device, which is connected to the electronic switches in parallel, and supplies electronic switches with high frequent currents.

In particular, the described design may be directly implemented in an advantageous manner in component carriers related to electronic devices such as switching converters, DC/DC converters, AC/DC converters, and miniaturized power electronics in general.

### Exemplary Embodiments

In the following, further exemplary embodiments of the component carrier and the method will be explained.

According to an embodiment, the capacitor device comprises at least two (in particular exactly two) single capacitors (capacitor elements), in particular connected in series. This may provide the advantage that a current path (in particular commutation loop) between the capacitor device and the electronic switch components is optimized.

MLCCs, may have a lower capacitance value when the voltage value increases. Nevertheless, it has been surprisingly found by the inventors that (a series connection of) two capacitors may efficiently overcome this drawback. The two capacitors may be of identical type, or may be of different type. Like the electronic switch components, they may be arranged side-by-side. Alternatively, the capacitors may be in direct physical contact. In an example, the distance between the electronic switch components (in the horizontal direction being parallel to the extension of the layers of the stack) is larger than the distance between the capacitors of the capacitor device. In an example, the resulting width of the capacitor device is such that the electronic switch components are partially arranged below said capacitor device.

According to an embodiment, the first electronic switch (transistor) and the second electronic switch (transistor) are embedded in a common encapsulation (mold) material: In particular, the two encapsulated electronic switches may be provided as a functional inlay. In this context, a functional inlay may comprise for example at least two transistor components (first transistor component, second transistor component) and the mold material. Thereby, the mold material may share at least one common surface with each of the transistor components, preferably two or more. In other words, the transistor components are at least partially encapsulated by the mold material. Manufacturing of a functional inlay may provide the advantage of higher reliability and accuracy.

According to a further embodiment, the first electronic switch component and the second electronic switch component are connected to form a half-bridge circuit. A half bridge circuit may comprise a so-called high-side electronic switch and a so-called low-side electronic switch which may be circuited in a cascade architecture. The two electronic switch components may be alternatingly switched on and off via corresponding control signals at inlet terminals. Two electronic switch terminals may be connected to one another at an outlet terminal of the half bridge. One or more of such half bridges may be used for fulfilling a certain electric function (for instance, a full bridge may be composed of two half bridges). Several half-bridges may be further connected in parallel.

According to a further embodiment, the first electronic switch component and the second electronic switch component are spaced apart from each other. Additionally or alternatively, the first electronic switch component and the second electronic switch component are electrically coupled, preferably directly coupled. Thereby, a reliable half-bridge circuit may be established in a minimal area. An electric coupling between the electronic switches may be realized for example with a metal trace that is connected with respective vias to the electronic switch terminals. In another example, a wire may be used for coupling. In a further example, between this coupling, a connection suitable for the power supply may be provided. One of the electronic switch components may form a high-side switch, and the other one of the electronic switch components may constitute a low-side switch.

According to a further embodiment, the first electronic switch component and the second electronic switch component are embedded within a common electrically insulating layer structure, in particular in a (central) core layer structure, of the stack.

By taking this measure, it is possible to obtain vertically very compact component carriers and to embed the electronic switch components in a common procedure. For instance, one or more pre-cut layer structures (for instance a pre-cut FR4 or prepreg sheet) may be provided with recesses in which the electronic switch components are accommodated. For example, the recesses may be closed at a bottom by a temporary carrier (such as an adhesive material stripe or plate). The electronic switch components may then be embedded by lamination, followed by the removal of the temporary carrier, which may be followed, in turn, by lamination of one or more further layers. Alternatively, it is also possible to place the electronic switch components on a central core (preferably of already fully cured material) and to build up the stack and complete the embedding procedure by lamination with various other layer structures. However, other processes for component integration may be used.

According to a further embodiment, the stack may not comprise a core layer structure (coreless build-up). Consequently, the integration of the electronic switch components is done in one or more of the further layer(s), in particular further electrically insulating layer structures (of the stack).

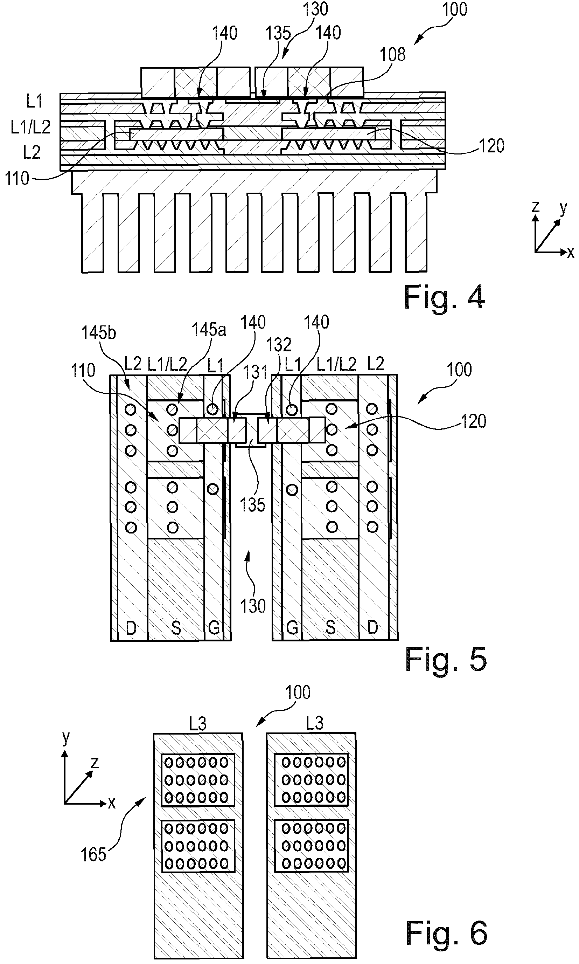

According to a further embodiment, the component carrier further comprises a gate drive conductor. Particularly, the gate drive conductor is arranged, in the direction (z) perpendicular to the directions of main extension (x, y) of the component carrier, between the capacitor device (in particular between the electrical terminal/pad of the capacitor device) and one of the electronic switch components. In particular, between the first capacitor (in particular a first pad/terminal) and the first electronic switch component (in particular a first gate) or between the second capacitor (in particular a second pad) and the second electronic switch component (in particular a second gate). However, in an embodiment, the electronic switch components' gate pad is not electrically connected (is independent) to the capacitor, and transmits a proper gate signal. The gate track may be connected to a respective electronic switch component (for example through the circled area shown in Figure 5 at reference sign 140).

This architecture may provide the advantage that the arrangement, in particular the commutation loop, is kept as small as possible, while the gate drive conductor/circuit may provide low inductance values. In an example, the gate drive conductor is routed between pre-arranged surface-mounted capacitor pads of the capacitor device, in particular one capacitor (element). In a further example, the gate drive conductor is electrically coupled to the first inner layer (acting as return path for the current). In a further example, the gate drive conductor is configured as a direct vertical connection between a capacitor (gate) terminal and an electronic switch component gate (terminal).

Conventionally, driver signals are routed at the component carrier front side, which can result in a space problem. It has now been surprisingly found that a gate drive conductor can be advantageously arranged directly between a (surface-mounted) capacitor device and the embedded electronic switch component.

According to a further embodiment, the gate drive conductor comprises at least one blind via, in particular a via filled with electrically conductive material, more in particular wherein the gate drive conductor further comprises an electrically conductive trace. Thus, the gate driver conductor may be realized in a straightforward manner using known component carrier manufacturing techniques (i.e. no additional manufacture process necessary). This may further provide the advantage that commutation loops can be formed in a small size due to short (copper filled) via connections between capacitor pads and the embedded electronic switches top sides.

According to a further embodiment, the component carrier further comprises a first commutation path from a power (DC) link connection via the first electronic switch component and the second electronic switch component to a ground connection.

According to a further embodiment, the component carrier further comprises a second commutation path between the capacitor device, the first electronic switch component, and the second electronic switch component.

Thereby, a first path for lower (frequency) current may be established without the capacitor device, while a second path for higher (frequency) current is established through the capacitor device. Since the high frequency current input of the capacitor device may be especially useful only in the later case, power resources may be managed advantageously.

According to a further embodiment, the component carrier further comprises a source conductor and a drain conductor, arranged, in the direction (z) perpendicular to the directions of main extension (x, y) of the component carrier, between the capacitor device and one of the electronic switch components.

In particular, the source conductor and/or the drain conductor comprises a blind via and a metal trace, more in particular a plurality of blind vias arranged one above the other with metal traces in between and/or one or more stacked vias, respectively.

Thereby, the conductors may be provided in a straightforward manner directly within the component carrier (PCB) manufacturing process, thereby saving energy and efforts.

According to a further embodiment, the source conductor and the drain conductor are electrically interconnected. In particular, the source conductor and the drain conductor are not electrically interconnected with the gate drive conductor. Accordingly, a highly efficient application of the embedded electronic switch components as switching devices may be enabled.

According to a further embodiment, the source, the drain, and the gate conductors are located on the same side of the electronic switch device. Additionally and or alternatively, one of said drain/source/gate conductor may be located on another (opposed) side of the electronic switch component.

According to a further embodiment, the capacitor device comprises at least two capacitor pads, and at least one capacitor pad is connected to at least one of said source conductors and/or said drain conductors, preferably at least one of the plurality of source conductors and drain conductors.

According to a further embodiment, the electronic switch components and the capacitor device are arranged in the stack, so that their electric connection pads/terminals are essentially aligned along the z-direction with the drain connector and/or the source connector. Thereby, an especially compact architecture may be enabled.

According to a further embodiment, the stack comprises two or more (electrically insulating) layer structures, in particular four or more, more in particular six or more. Depending on the desired application, very thin layer build-ups but also a stack with a high layer count may be realized. Further, the stack may be scalable depending on the applied current values.

According to a further embodiment, the capacitor device is at least partially surrounded by a surface finish. According to a further embodiment, the capacitor device is at least partially placed on a solder mask. In an example, the capacitor device is surface mounted on a main surface of the component carrier. The outermost layer of the component carrier (stack) may be a surface finish and the capacitor device may be arranged (partially) surrounded by the surface finish layer structure. Furthermore, the capacitor device may be placed on a solder mask/resist layer structure that forms an outer layer of the stack. Alternatively, the capacitor device may be placed on an electrically insulating layer structure.

According to a further embodiment, the component carrier further comprises a heat sink (heat removal structure), arranged below the electronic switch components.

In the context of this document, the term "heat sink" may refer to any structure suitable for dissipating thermal energy, in particular a significant amount of thermal energy in comparison to other component carrier parts. For example, such a heat sink may be made of a thermally highly conductive material such as copper or aluminum. The heat sink may have a base plate section connected to an exterior surface of the stack of component carrier material and may comprise a plurality of heat dissipation (cooling) fins connected to the base plate section and having a high surface for proper heat exchange with an environment. The base plate shape of such a heat sink may perfectly fit with a corresponding (bottom) main surface of the stack. In an embodiment, the heat sink may be produced by at least one of sintering, soldering, thermal adhesion, additive manufacturing, in particular three-dimensional printing.

In an embodiment, the interconnection towards the heatsink may be spreading the thermal energy. There might be a copper inlay added between one or more of the conductive (copper) layers to spread the heat more efficiently.

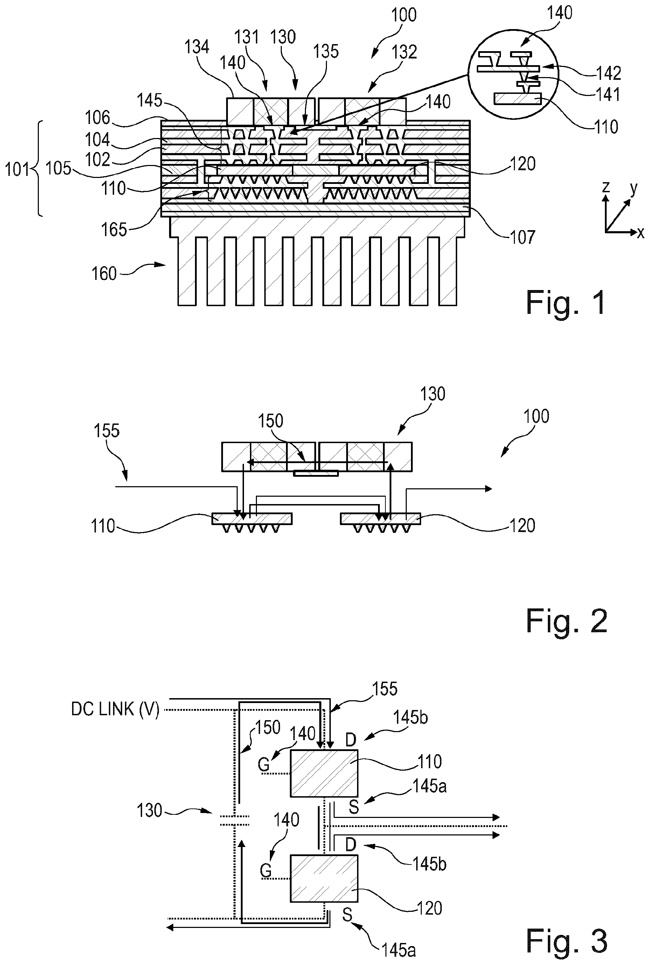

In an embodiment, the heat sink may be connected, in particular directly connected, to a component e.g. an electronic switch component. Alternatively, the heat sink may be indirectly connected to a component via a further heat conducting/metallic structure, e.g. vias and/or layers. There may be the possibility that a plurality of components are connected to the heat sink (see e.g. Figure 1).

In an embodiment, the heat sink can be cooled by a fluid (e.g. air and/or water).

According to a further embodiment, a thermal enhancement layer (structure) is arranged between the heat sink and the electronic switch components, in particular the thermal enhancement layer may be the outermost layer of the stack (at the bottom, opposed to the main surface, where the capacitor device is arranged). In another embodiment, the thermal enhancement layer is arranged on a side of the stack. The thermal enhancement layer may e.g. comprise a standard prepreg, a thermal prepreg, or outside isolation (such as standard prepreg and additional thermal interface on the outside).

According to a further embodiment, the component carrier further comprises a plurality of thermally conductive vias, extending vertically (along z) from the first electronic switch component and the second electronic switch component in a direction opposed to the capacitor device. This may provide the advantage that thermal energy is removed efficiently and reliably from the electronic switch components (which may produce a lot of heat and there may exist a danger of overheating). The thermally conductive vias may dissipate heat in interplay with the heat sink, thereby removing heat especially efficiently. Accordingly, an advantageous thermal path (from the electronic switch components through the plurality of vias (the thermal enhancement layer) to the heat sink may be provided.

In an embodiment, the component carrier comprises at least one temperature sensor component embedded in the stack for sensing information indicative of temperature in the stack. Such a temperature sensor component (which may be embodied as a temperature sensitive resistor, or a semiconductor chip with heat sensing capability) may locally determine the temperature in an interior of the stack to thereby provide an indication of a possible overheating during operation of the component carrier. In particular, the temperature sensor component embedded in the stack can be arranged very close to one or more main heat sources of the component carrier, i.e. the electronic switch components (and/or the capacitor device) or more particularly a most heat emitting surface thereof, so as to be capable of sensing locally most relevant temperature information. The temperature sensor component may be in direct contact with a respective one of the electronic switch components (and/or capacitor(s). The temperature sensor component may be embodied as passive electric member.

In an embodiment, at least one electronic switch is configured as a thermal sensing device (temperature sensor), in particular a temperature sensing transistor. This may provide the advantage that a temperature with respect to the stack can be monitored/regulated. Thereby, overheating may be prevented.

According to a further embodiment, the component carrier is used for a power electronics application. The described component carrier may be used in all kind of electronics to supply themselves or convert/invert into different power domains. In a further example, the component carrier is applied within a telecommunication equipment and/or a heavy duty machine. In this context, the term "heavy duty machine" may in particular refer to a machine dedicated for environments and task that require a high amount of energy/power. In an example, such a machine may comprise an electric powertrain, e.g. for a truck, a tractor, a train, a ship, a construction machine, etc.

In an embodiment, the horizontal extensions (along x, y) of the (first/second) capacitor may be adapted to the horizontal extensions of the (first second) electronic switch component(s). In an example, the horizontal extension of a capacitor is (essentially) comparable to the horizontal extension of the corresponding electronic switch component. The term "essentially" may hereby refer to a difference of 20 per cent or less.

In an embodiment, the component carrier is configured for reducing power or for switching off at least one of the first electronic switch component and the second electronic switch component (and/or the capacitor(s)) when information sensed by the at least one temperature sensor component indicates overheating of the stack. For this purpose, the temperature sensor component may transmit a signal indicative of the present temperature within the stack to the at least one control chip. The latter may then adjust its control of the electronic switch component(s) accordingly so as to bring back the critical detected temperature into an acceptable range.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material or ABF. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections (e.g. copper inlays to feed more current regarding larger structures) may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates the commutation paths in a component carrier according to a further exemplary embodiment of the invention.
Figure 3 illustrates commutation paths between the electronic switch components and the capacitor device according to an exemplary embodiment of the invention.
Figure 4 illustrates another cross-sectional view of a component carrier according to a further exemplary embodiment of the invention.
Figure 5 illustrates a top view on a component carrier according to an exemplary embodiment of the invention.
Figure 6 illustrates a bottom view (from below) on a component carrier according to an exemplary embodiment of the invention.
Figures 7 and 8 illustrate half bridges according to exemplary embodiments of the invention.

### Detailed Description of the Drawings

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, the invention may provide the following advantages: optimized signal performance on gate drive and commutation loop, thermally enhanced connection of the transistors, and miniaturized switching cell.

According to a further exemplary embodiment, an implementation of the invention can be described as follows:
Embedded components with direct copper connection offer excellent signal performance. If combined with power electronics, transistors can be arranged in a half bridge configuration. To optimize the switching performance, a capacitor installed next to the half bridge supplies the transistors with high frequent currents. Due to these fast flowing currents, the distance should be kept as small as possible. This reduces the so-called commutation loop impedance, in particular (communication loop) inductance. Less parasitics in the system has the advantage of low voltage overshoot and less ringing. Due to the configuration, the transistors are embedded inside the PCB. On the backside of the PCB, the heatsink is mounted to ensure proper cooling of the buried parts. This means that a population of electrical components on the backside is limited due to the size of the heat sink. Arranging the capacitors on the front side, where usually the driver signals are routed often result in a space problem. The fact that MLCCs (multi-layer ceramic capacitors) have a lower capacitance value while the voltage increases means that a single capacitor in the commutation loop is often not enough. A series connection of two capacitors divides the capacitance value by a factor of two, but the resulting overall capacitance is more because of the voltage drop. The size can be (perfectly) adapted to the size of the transistors. A combination of MLCCs, the gate drive circuit, and the embedded transistors leads to excellent signal performance, in particular if routed like follows: The high-side transistors drain as well as the low-side transistors source is connected from the embedded dies by micro-vias to the outside of the PCB. The vias in this configuration are copper filled. Transistors and capacitors are arranged in a way that the solder pads are aligned exactly on the same position as the drain and the source. Due to the copper filling, the vias are placed inside the capacitors electrical connection pads. On the one hand side, the resulting commutation loop is as short as possible on the other hand the gate signal can be routed underneath the top side surface mounted MLCC. This keeps the gate drive aligned with the first inner layer which acts as return path and lowers the gate drive losses in operation. Transistors used for this concept are e.g. Hemts (high electron mobility transistors) or SiC devices in horizontal (planar) configuration. This means that the current flow is along the front side of the transistor. The die's fully metalized backside is connected to the transistors drain or source potential on the front side. Arranged alongside with the heatsink, it is used for cooling purpose. The laminated thermal prepreg offers electrical isolation while the heat transfer through this layer is enhanced.

**Figure 1** shows a cross-sectional view of a component carrier 100 according to an exemplary embodiment of the invention. The component carrier 100 comprises a stack 101 with a plurality of electrically conductive layer structures 104 and electrically insulating layer structures 102. A first electronic switch component 110 and a second electronic switch component 120 are embedded in the stack 101 on the same vertical (in z-direction, i.e. perpendicular to the extension of the layers of the stack 101) level, specifically in an electrically insulating core layer structure 105. The electronic switch components 110, 120 are realized as transistor components. The electronic switch components 110, 120 are embedded side-by-side (next to each other but spatially separated with component carrier material in between) in the core layer structure 105 of the stack 101 and are electrically connected in series to form a half-bridge (not shown in Figure 1, see Figures 2, 3, 7 and 8).

Further, the component carrier 100 comprises a capacitor device 130, electrically connected in parallel to the first electronic switch component 110 and the second electronic switch component 120. The capacitor device 130 is surface-mounted to the stack 101, so that the first electronic switch component 110 and the second electronic switch component 120 are partially arranged below the capacitor device 130 in a the vertical (z) direction. The capacitor device 130 comprises two single capacitors 131, 132 elements that are connected in series by a capacitor connector 135, here configured as a metal trace. Each capacitor 131, 132 further comprises two electrical connection pads/terminals 134. Hereby, the first capacitor 131 is associated with the first electronic switch component 110 and the second capacitor 132 is associated with the second electronic switch component 120. The capacitor device 130 is partially surrounded by a surface finish 106 layer structure of the stack 101 and placed upon a solder mask layer structure 108.

The electric connection described in the following is, in this example, the same between the first electronic switch component 110 and the first capacitor 131 and between the second electronic switch component 120 and the second capacitor 132. For better overview, only the first is described in the following.

The component carrier 100 further comprises a gate drive conductor 140, arranged, in the vertical direction (z) between the electrical terminals 134 of the capacitor device 130 (in particular the first capacitor 131) and a first pad of the first electronic switch component 110. The gate drive conductor 140 comprises in this specific example three blind vias 141 arranged on top of each other with respective electrically conductive traces 142 in between.

The component carrier 100 further comprises a source conductor 145a and a drain conductor 145b, both arranged in the vertical direction (z) between the capacitor device 130 and the first electronic switch component 110, 120. Like the gate drive conductor 140, each of the source conductor 145a and the drain conductor 145b comprises three respective blind vias on top of each other with metal traces in between. The source conductor 145a and the drain conductor 145b are electrically interconnected by the metal traces. It should be noticed that the interconnected source conductor 145a and drain conductor 145b are not electrically interconnected with the gate drive conductor 140. The gate drive conductor 140 is electrically connected to the first electronic switch component 110 as the interconnected source conductor 145a and drain conductor 145b. The gate drive connector 140 is designed as a straight vertical line between a gate driver terminal of the capacitor device 130 and a gate terminal of the first electronic switch component 110. The source connector 145a and the drain connector 145b are designed as straight vertical lines between source/drain terminals of the capacitor device 130 and source/drain terminals of the first electronic switch component 110, respectively.

The component carrier 100 further comprises a heat sink 160 arranged below the electronic switch components 110, 120 in the vertical direction at the bottom of the stack 101. A thermal enhancement layer 107 is arranged between layers 102, 104 of the stack 101 and the actual heat sink 160 structure. The heat sink 160 is surface mounted to the stack 101, for example by sintering, soldering or thermal adhesion. The heat sink 160 comprises metal (e.g. aluminium) and is implemented as a plurality of heat-distribution (cooling) fins that protrude from a base layer/plate.

The component carrier further comprises a plurality of thermally conductive vias 165 that extend vertically from the first electronic switch component 110 and the second electronic switch component 120 in a direction opposed to the capacitor device 130 and towards the heat sink 160. In this example, the plurality of thermally conductive vias 165 is electrically connected by a via to a metal trace of the source connector 145a and the drain connector 145b. Thereby, the heat is spread to provide an efficient cooling.

**Figure 2** illustrates the current paths (commutation circuits) between capacitor device 100 and electronic switch components 110, 120 for the component carrier 100 described for Figure 1. In comparison to Figure 1, all structures but the electronic switch components 110, 120 and the capacitor device 130 have been omitted for the sake of clarity. For better overview, Figure 2 is described together with **Figure 3** that shows in detail said current paths.

A first commutation path 155 (low frequency current path) is formed from a power (here DC) link connection via the first electronic switch component 110 and the second electronic switch component 120 (that are connected in series to form a half-bridge) to a ground connection. A second commutation path 150 (high frequency current path) is formed between the capacitor device 130, the first electronic switch component 110, and the second electronic switch component 120, wherein the capacitor device 130 is connected in parallel to the series-connected electronic switch components 110, 120. In other words, a low frequency current path is handled by the electronic switch components 110, 120 alone, while a high frequency current path is configured as a power loop between the electronic switch components 110, 120 as high frequency switching devices and the commutation capacitors 131, 132.

The capacitor device 130, installed next to the electronic switch components 110, 120 half bridge, supplies the electronic switch components 110, 120 with high frequent currents. To improve these fast flowing currents, the distance between the elements 110, 120, 130 is kept as small as possible. This reduces the so-called commutation loop inductance and parasitics, while low voltage overshoots and ringing are avoided. A highly reliable and efficient signal performance can be achieved with this architecture.

**Figure 4** illustrates another cross-sectional view of a component carrier 100 according to a further exemplary embodiment of the invention. The design is very similar to the one described for Figures 1 and 2. Yet, the number of electrically insulating layer structures 102 has been reduced from six to four. In line with this miniaturization, the number of vias of the gate driver connector 140 as well as the source connector 145a and the drain connector 145b, respectively, have been reduced from three to two. The plurality of heat removing vias 165 is implemented as one via row instead of two.

**Figure 5** illustrates a top view on the component carrier 100 of Figure 4 according to an exemplary embodiment of the invention. It can be seen that, next the arrangement of capacitor device 130 and electronic switch components 110, 120, further electronic switch components with respective gate driver connections and source/drain connections are embedded in the stack 101. The dot-shaped forms indicate connections to the transistors in stacked via configuration.

**Figure 6** illustrates a bottom view (from below) on the component carrier 100 of Figure 4 according to an exemplary embodiment of the invention. Here, the plurality of thermally conductive vias 165 can be seen that transport heat produced by the electronic switch components 110, 120 to the lower outer surface of the stack 101, specifically to the heat sink 160.

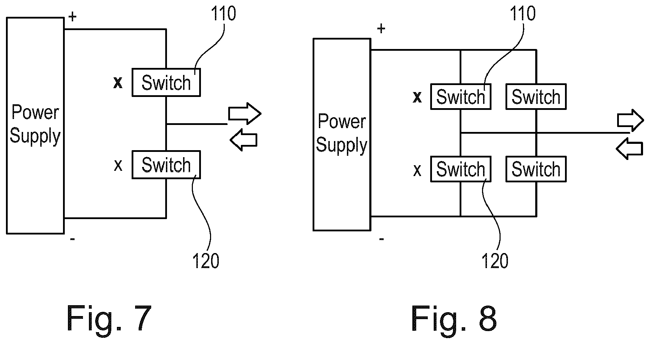

Figures 7 and 8 illustrate half bridges according to exemplary embodiments of the invention. **Figure 7** shows two electronic switch components 110, 120, configured as switching devices, that are connected to a power supply and are interconnected in series to form a half bridge. **Figure 8** shows an embodiment, wherein further electronic switch components are connected in parallel to form further half bridge(s).

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

### Reference signs

- 100: Component carrier
- 101: Stack
- 102: Electrically insulating layer structure
- 104: Electrically conductive layer structure
- 105: Core layer structure
- 106: Surface finish
- 107: Thermal enhancement layer
- 108: Solder mask/resist
- 110: First electronic switch component
- 120: Second electronic switch component
- 130: Capacitor device
- 131: First capacitor
- 132: Second capacitor
- 134: Capacitor device pad
- 135: Capacitor connector
- 140: Gate drive conductor
- 141: Gate drive conductor via
- 142: Gate drive conductor metal trace
- 145: Source conductors and drain conductors
- 145a: Source conductor
- 145b: Drain conductor
- 150: Second commutation (high frequency current) path
- 155: First commutation (low frequency current) path
- 160: Heat sink
- 165: Plurality of thermally conductive vias

## Claims

1. A component carrier (100), wherein the component carrier (100) comprises:
a stack (101) comprising at least one electrically conductive layer structure (104) and/or at least one electrically insulating layer structure (102);
a first electronic switch, in particular transistor, component (110) and a second electronic switch, in particular transistor, component (120) assembled, in particular embedded, side-by-side to the stack (101); and
a capacitor device (130), electrically connected in parallel to the first electronic switch component (110) and the second electronic switch component (120) ;
wherein the capacitor device (130) is assembled, in particular surface-mounted, to the stack (101), so that
the first electronic switch component (110) and the second electronic switch component (120) are at least partially arranged below the capacitor device (130) in a direction (z) perpendicular to the directions of main extension (x, y) of the component carrier (100).

2. The component carrier (100) according to claim 1, wherein
the capacitor device (130) comprises at least two single capacitors (131, 132), in particular connected in series.

3. The component carrier (100) according to claim 1 or 2, wherein the first electronic switch component (110) and the second electronic switch component (120) are connected to form a half-bridge circuit.

4. The component carrier (100) according to any one of the preceding claims,
wherein the first electronic switch component (110) and the second electronic switch component (120) are spaced apart from each other; and/or
wherein the first electronic switch component (110) and the second electronic switch component (120) are electrically coupled.

5. The component carrier (100) according to any one of the preceding claims, wherein the first electronic switch component (110) and the second electronic switch component (120) are embedded within a common electrically insulating layer structure (102), in particular in a core layer structure (105), of the stack (101).

6. The component carrier (100) according to any one of the preceding claims, further comprising:
a gate drive conductor (140), arranged, in the direction (z) perpendicular to the directions of main extension (x, y) of the component carrier (100), between the capacitor device (130) and one of the electronic switch components (110, 120),
in particular between the first capacitor (131) and the first electronic switch component (110), in particular a first gate, or between the second capacitor (132) and the second electronic switch component (120), in particular a second gate.

7. The component carrier (100) according to claim 6,
wherein the gate drive conductor (140) comprises at least one blind via (141, 142), in particular a via filled with electrically conductive material, more in particular wherein the gate drive conductor (140) further comprises an electrically conductive trace.

8. The component carrier (100) according to any one of the preceding claims, further comprising:
a first commutation path (155) from a powerlink connection via the first electronic switch component (110) and the second electronic switch component (120) to a ground connection; and/or
a second commutation path (150) between the capacitor device (130), the first electronic switch component (110), and the second electronic switch component (120).

9. The component carrier (100) according to any one of the preceding claims, further comprising:
a source conductor (145a) and a drain conductor (145b), arranged, in the direction (z) perpendicular to the directions of main extension (x, y) of the component carrier (100), between the capacitor device (130) and one of the electronic switch components (110, 120),
in particular wherein the source conductor (145a) and/or the drain conductor (145b) comprises a blind via and/or a metal trace,
more in particular a plurality of blind vias arranged one above the other with metal traces in between, respectively.

10. The component carrier (100) according to claim 9,
wherein the source conductor (145a) and the drain conductor (145b) are electrically interconnected,
in particular wherein the source conductor (145a) and the drain conductor (145b) are not electrically interconnected with the gate drive conductor (140).

11. The component carrier (100) according to claim 9 or 10,
wherein the capacitor device (130) comprises at least two capacitor pads (134), and
wherein at least one capacitor pad (134) is connected to at least one of the source conductors and/or the drain conductors (144).

12. The component carrier (100) according to any one of the preceding claims, wherein the capacitor device (130) is at least partially surrounded by a surface finish (106).

13. The component carrier (100) according to any one of the preceding claims,
further comprising: a heat sink (160), arranged below the electronic switch components (110, 120), in particular, wherein a thermal enhancement layer (107) is arranged between the heat sink (160) and the electronic switch components (110, 120);
and/or
further comprising: a plurality of thermally conductive vias (165), extending vertically from the first electronic switch component (110) and the second electronic switch component (120) in a direction opposed to the capacitor device (130);
and/or
wherein the first electronic switch component (110) and/or the second electronic switch component (120) is configured as a temperature measurement device.

14. A method of manufacturing a component carrier (100), the method comprises:
forming a stack (101) comprising at least one electrically conductive layer structure (104) and/or at least one electrically insulating layer structure (102);
assembling, in particular embedding, a first electronic switch component (110) and a second electronic switch component (120) side-by-side to the stack (101); and
assembling, in particular surface-mounting, a capacitor device (130) to the stack (101) and electrically connecting the capacitor device (130) in parallel to the first electronic switch component (110) and the second electronic switch component (120), so that
the first electronic switch component (110) and the second electronic switch component (120) are at least partially arranged below the capacitor device (130) in a direction (z) perpendicular to the directions of main extension (x, y) of the component carrier (100).

15. Using the component carrier (100) according to any one of the claims 1 to 13 in a power electronics application, in particular a telecommunication application and/or a heavy duty machine application.
